# EUROPÄISCHE PATENTANMELDUNG

(11) **EP 2 429 009 A2**
(43) Veröffentlichungstag der Anmeldung: **14.03.2012**
(21) Anmeldenummer: 11183323.2
(22) Anmeldetag: 18.09.2008
(51) Int. Cl.: H01L 51/52, H01L 33/00

(54) **Optoelektronisches Bauelement und Verfahren zur Herstellung eines optoelektronischen Bauelements**

(30) Priorität: 20.09.2007 DE 102007044865; 31.10.2007 DE 102007052181
(62) Teilanmeldung aus: 08164593.9
(71) Anmelder: OSRAM Opto Semiconductors GmbH, 93055 Regensburg (DE)
(72) Erfinder: von Malm, Norwin, 93152 Nittendorf - Thumhausen (DE); Heuser, Karsten, 91056 Erlangen (DE)
(74) Vertreter: Epping - Hermann - Fischer

(57) **Zusammenfassung**

Ein optoelektronisches Bauelement weist insbesondere ein Substrat (1), eine erste Elektrode (2) auf dem Substrat (1), eine strahlungsemittierende Schichtenfolge (3) mit einem aktiven Bereich (30), der im Betrieb eine elektromagnetische Primärstrahlung abstrahlt, eine für die Primärstrahlung transparente zweite Elektrode (4) auf der strahlungsemittierenden Schichtenfolge (3) und eine auf der zweiten Elektrode (4) abgeschiedene Verkapselungsanordnung (10) auf, wobei die Verkapselungsanordnung (10) einen Schichtenstapel mit zumindest einer ersten Barrierenschicht (6) und zumindest einer ersten, die Primärstrahlung zumindest teilweise in elektromagnetische Sekundärstrahlung umwandelnden Wellenlängenkonversionsschicht (5) aufweist und die Verkapselungsanordnung (10) zumindest teilweise für die Primärstrahlung und/oder für die Sekundärstrahlung transparent ist.

## Beschreibung

Diese Patentanmeldung beansprucht die Prioritäten der deutschen Patentanmeldung 10 2007 044 865.3 und der deutschen Patentanmeldung 10 2007 052 181.4, deren Offenbarungsgehalte hiermit durch Rückbezug aufgenommen werden.

Im Folgenden werden ein optoelektronisches Bauelement mit einer strahlungsemittierenden Schichtenfolge und ein Verfahren zur Herstellung eines optoelektronischen Bauelements nach den Oberbegriffen der unabhängigen Patentansprüche angegeben.

Optoelektronische Bauelemente mit strahlungsemittierenden Schichtenfolgen können elektromagnetische Strahlung emittieren, die bei einem Beobachter einen Farbeindruck erwecken kann. Dabei kann es erstrebenswert sein, dass dieser Farbeindruck der strahlungsemittierenden Schichtenfolge zumindest teilweise mittels Lumineszenzkonvertern modifiziert wird.

Zumindest eine Aufgabe von bestimmten Ausführungsformen ist es, ein optoelektronisches Bauelement mit einer strahlungsemittierenden Schichtenfolge anzugeben, das eine Wellenlängenkonversionsschicht aufweist. Weiterhin ist es eine Aufgabe von bestimmten Ausführungsformen, ein Verfahren zur Herstellung eines optoelektronischen Bauelements anzugeben.

Diese Aufgaben werden durch einen Gegenstand und ein Verfahren mit den Merkmalen der unabhängigen Patentansprüche gelöst. Vorteilhafte Ausführungsformen und Weiterbildungen des Gegenstands sind in den abhängigen Ansprüchen gekennzeichnet und gehen weiterhin aus der nachfolgenden Beschreibung und den Zeichnungen hervor.

Ein optoelektronisches Bauelement gemäß einer Ausführungsform umfasst insbesondere
- ein Substrat,
- eine erste Elektrode auf dem Substrat,
- eine strahlungsemittierende Schichtenfolge mit einem aktiven Bereich, der im Betrieb eine elektromagnetische Primärstrahlung abstrahlt,
- eine für die Primärstrahlung transparente zweite Elektrode auf der strahlungsemittierenden Schichtenfolge und
- eine auf der zweiten Elektrode abgeschiedene Verkapselungsanordnung,
   wobei
- die Verkapselungsanordnung einen Schichtenstapel mit zumindest einer ersten Barrierenschicht und zumindest einer ersten, die Primärstrahlung zumindest teilweise in elektromagnetische Sekundärstrahlung umwandelnden Wellenlängenkonversionsschicht aufweist und
- die Verkapselungsanordnung zumindest teilweise für die Primärstrahlung und/oder für die Sekundärstrahlung transparent ist.

Dass eine Schicht oder ein Element "auf" oder "über" einer anderen Schicht oder einem anderen Element angeordnet oder aufgebracht ist, kann dabei hier und im Folgenden bedeuten, dass die eine Schicht oder das eine Element unmittelbar im direkten mechanischen und/oder elektrischen Kontakt auf der anderen Schicht oder dem anderen Element angeordnet ist. Weiterhin kann es auch bedeuten, dass die eine Schicht oder das eine Element mittelbar auf beziehungsweise über der anderen Schicht oder dem anderen Element angeordnet ist. Dabei können dann weitere Schichten und/oder Elemente zwischen der einen und der anderen Schicht angeordnet sein.

Die Verkapselungsanordnung kann geeignet sein, die Elektroden und die strahlungsemittierende Schichtenfolge vor Feuchtigkeit und/oder oxidierenden Substanzen wie etwa Sauerstoff zu schützen. Gleichzeitig kann dieselbe Verkapselungsanordnung die Möglichkeit bieten, den Leuchteindruck, der bei einem Beobachter durch das optoelektronische Bauelement erweckt werden kann, durch geeignete Wahl und Anordnung der Wellenlängenkonversionsschicht einzustellen. Durch die Kombination der ersten Barrierenschicht und der ersten Wellenlängenkonversionsschicht in der Verkapselungsanordnung kann somit ein kompaktes optoelektronisches Bauelement ermöglicht werden, das weiterhin mittels eines technisch einfach kontrollierbaren und kostengünstigen Herstellungsprozess hergestellt werden kann.

Eine herkömmliche Verkapselung in Form eines Volumenvergusses oder eines Deckels kann damit unnötig sein. Dabei kann die Verwendung einer Wellenlängenkonversionsschicht in der Verkapselungsanordnung vorteilhaft sein, um beispielsweise eine differenzielle Farbalterung zu vermeiden, die bei der Verwendung mehrerer verschiedener aktiver Bereiche zur Erzeugung von Mischlicht auftreten kann. Zum anderen kann der Farbort des Leuchteindrucks des optoelektronischen Bauelements unabhängig von den elektronischen Eigenschaften der strahlungsemittierenden Schichtenfolge optimiert werden.

Insbesondere kann das optoelektronische Bauelement eine Überlagerung aus der Primärstrahlung und der Sekundärstrahlung abstrahlen. Dabei kann ein Teil der Primärstrahlung die Wellenlängenkonversionsschicht und auch die erste Barrierenschicht unkonvertiert durchqueren und aus der Verkapselungsanordnung austreten. Weiterhin kann auch die elektromagnetische Sekundärstrahlung aus der Verkapselungsanordnung austreten und von dieser abgestrahlt werden. Für einen externen Beobachter kann daher ein mischfarbiger Leuchteindruck durch die Überlagerung der elektromagnetischen Primärstrahlung und elektromagnetischen Sekundärstrahlung wahrgenommen werden. Der mischfarbige Leuchteindruck kann dabei von den relativen Anteilen der Primärstrahlung und Sekundärstrahlung zueinander abhängen. Die Primärstrahlung, und die Sekundärstrahlung können voneinander verschiedene Wellenlängenbereiche aufweisen. Dadurch kann eine Mischung von beispielsweise unterschiedlichen Farben der elektromagnetischen Strahlung erzeugt werden, die zu einer Gesamtstrahlung mit der gewünschten, resultierenden Farbe führen.

Die erste Barrierenschicht kann ein Material aufweisen, das geeignet ist, die Elektroden und die organische Halbleiterschichtenfolge vor schädigenden Einflüssen der Umgebung zu schützen, also etwa vor Sauerstoff und/oder Feuchtigkeit. Insbesondere kann die Barrierenschicht undurchlässig oder nur schwer durchdringbar für Sauerstoff und/oder Feuchtigkeit sein. Beispielsweise kann die Barrierenschicht ein Oxid, ein Nitrid oder ein Oxynitrid aufweisen. Beispielsweise kann das Oxid, Nitrid oder Oxynitrid weiterhin Aluminium, Silizium, Zinn oder Zink umfassen. Die Barrierenschicht kann dabei dielektrische oder auch elektrisch leitende Eigenschaften aufweisen und beispielsweise Siliziumoxid, etwa SiO₂, Siliziumnitrid, etwa Si₂N₃, Siliziumoxynitrid (SiOₓN_{y}), Aluminiumoxid, etwa Al₂O₃, Aluminiumnitrid, Zinnoxid, Indiumzinnoxid, Zinkoxid oder Aluminiumzinkoxid aufweisen. Alternativ oder zusätzlich kann die Barrierenschicht ein Material aufweisen, das geeignet ist, Sauerstoff und/oder Feuchtigkeit zu binden und dadurch am Durchdringen der Barrierenschicht hindern. Geeignete Materialien hierfür können beispielsweise Alkali- und Erdalkalimetalle sein.

Die erste Barrierenschicht kann beispielsweise durch ein Aufbringverfahren wie etwa ein Aufdampf- oder Abscheideverfahren herstellbar sein. Ein solches Aufbringverfahren kann ein Verfahren zur chemischen Gasphasenabscheidung ("chemical vapor deposition", CVD) oder ein Verfahren zur physikalischen Gasphasenabscheidung ("physical vapor deposition", PVD) sein oder eine Kombination aus solchen Verfahren sein. Beispielhaft für solche Aufbringverfahren seien thermisches Verdampfen, Elektronenstrahlverdampfen, Laserstrahlverdampfen, Lichtbogenverdampfen, Molekularstrahlepitaxie, Sputtern, Ionenplattieren und plasmaunterstützte chemische Gasphasenabscheidung genannt.

Weiterhin kann die erste Wellenlängenkonversionsschicht einen oder mehrere Wellenlängenkonversionsstoffe aufweisen, die geeignet sind, die elektromagnetische Primärstrahlung zumindest teilweise zu absorbieren und als Sekundärstrahlung mit einem zumindest teilweise von der Primärstrahlung verschiedenen Wellenlängenbereich zu emittieren. Die elektromagnetische Primärstrahlung und elektromagnetische Sekundärstrahlung können eine oder mehrere Wellenlängen und/oder Wellenlängenbereiche in einem infraroten bis ultravioletten Wellenlängenbereich umfassen, insbesondere in einem sichtbaren Wellenlängenbereich. Dabei können das Spektrum der Primärstrahlung und/oder das Spektrum der Sekundärstrahlung schmalbandig sein, das heißt, dass die Primärstrahlung und/oder die Sekundärstrahlung einen einfarbigen oder annähernd einfarbigen Wellenlängenbereich aufweisen können. Das Spektrum der Primärstrahlung und/oder das Spektrum der Sekundärstrahlung kann alternativ auch breitbandig sein, das heißt, dass die Primärstrahlung und/oder die Sekundärstrahlung einen mischfarbigen Wellenlängenbereich aufweisen kann, wobei der mischfarbige Wellenlängenbereich ein kontinuierliches Spektrum oder mehrere diskrete spektrale Komponenten mit verschiedenen Wellenlängen aufweisen kann. Beispielsweise kann die elektromagnetische Primärstrahlung einen Wellenlängenbereich aus einem ultravioletten bis grünen Wellenlängenbereich aufweisen, während die elektromagnetische Sekundärstrahlung einen Wellenlängenbereich aus einem blauen bis infraroten Wellenlängenbereich aufweisen kann. Besonders bevorzugt können die Primärstrahlung und die Sekundärstrahlung überlagert einen weißfarbigen Leuchteindruck erwecken. Dazu kann die Primärstrahlung vorzugsweise einen blaufarbigen Leuchteindruck erwecken und die Sekundärstrahlung einen gelbfarbigen Leuchteindruck, der durch spektrale Komponenten der Sekundärstrahlung im gelben Wellenlängenbereich und/oder spektrale Komponenten im grünen und roten Wellenlängenbereich entstehen kann.

Der Wellenlängenkonversionsstoff kann dabei einen oder mehrere der folgenden Materialien aufweisen: Granate der Seltenen Erden und der Erdalkalimetalle, beispielsweise YAG:Ce³⁺, Nitride, Nitridosilikate, Sione, Sialone, Aluminate, Oxide, Halophosphate, Orthosilikate, Sulfide, Vanadate und Chlorosilikate. Weiterhin kann der Wellenlängenkonversionsstoff zusätzlich oder alternativ ein organisches Material umfassen, das aus einer Gruppe ausgewählt sein kann, die Perylene, Benzopyrene, Coumarine, Rhodamine und Azo-Farbstoffe umfasst. Weitere Beispiele und Ausführungsformen sind in der Patentanmeldung DE 102007049005.6 beschrieben, deren Offenbarungsgehalt hiermit durch Rückbezug aufgenommen wird. Die Wellenlängenkonversionsschicht kann geeignete Mischungen und/oder Kombinationen der genannten Wellenlängenkonversionsstoffe aufweisen. Dadurch kann es beispielsweise möglich sein, dass, wie oben beschrieben, die Wellenlängenkonversionsschicht in einem blauen ersten Wellenlängenbereich absorbiert und in einem zweiten Wellenlängenbereich emittiert, der grüne und rote Wellenlängen und/oder gelbe Wellenlängenbereiche aufweist.

Weiterhin kann die Wellenlängenkonversionsschicht ein transparentes Matrixmaterial umfassen, das den oder die Wellenlängenkonversionsstoffe umgibt oder enthält oder das an den oder die Wellenlängenkonversionsstoffe chemisch gebunden ist. Das transparente Matrixmaterial kann beispielsweise Siloxane, Epoxide, Acrylate, Methylmethacrylate, Imide, Carbonate, Olefine, Styrole, Urethane oder Derivate davon in Form von Monomeren, Oligomeren oder Polymeren und weiterhin auch Mischungen, Copolymere oder Verbindungen damit aufweisen. Beispielsweise kann das Matrixmaterial ein Epoxidharz, Polymethylmethacrylat (PMMA), Polystyrol, Polycarbonat, Polyacryl, Polyurethan oder ein Silikonharz wie etwa Polysiloxan oder Mischungen daraus umfassen oder sein.

Der oder die Wellenlängenkonversionsstoffe können dabei homogen im Matrixmaterial verteilt sein. Weiterhin kann die Wellenlängenkonversionsschicht mehrere Wellenlängenkonversionsstoffe aufweisen, die in verschiedenen Schichten in der Wellenlängenkonversionsschicht angeordnet sind. Insbesondere können der oder die Wellenlängenkonversionsstoffe im Matrixmaterial, das vor dem Aufbringen der Wellenlängenkonversionsschicht in einer flüssigen Phase vorliegen kann, enthalten sein. Das flüssige Matrixmaterial mit dem oder den Wellenlängenkonversionsstoffen kann dann über der zweiten Elektrode aufgebracht werden und durch Trocknungs- und/oder Vernetzungsprozesse schichtförmig als Wellenlängenkonversionsschicht ausgebildet werden. Alternativ kann das Matrixmaterial mit dem Wellenlängenkonversionsstoff auch aufgedampft werden. Weiterhin kann das Matrixmaterial mit dem Wellenlängenkonversionsstoff danach durch Vernetzungsreaktionen ausgehärtet werden.

Der oder die Wellenlängenkonversionsstoffe können in Form von Partikeln ausgeformt sein, die eine Größe von 2 bis 10 µm aufweisen können. Weiterhin können die Partikel zumindest teilweise die Primärstrahlung und/oder die Sekundärstrahlung streuen. Damit kann ein Wellenlängenkonversionsstoff gleichzeitig als ein Leuchtzentrum, das Strahlung der Primärstrahlung teilweise absorbiert und eine Sekundärstrahlung emittiert, und als Streuzentrum für die Primärstrahlung und/oder die Sekundärstrahlung ausgebildet sein. Derartige Streueigenschaften eines Wellenlängenkonversionsstoffs können somit zu einer verbesserten Strahlungsauskopplung führen. Die Streuwirkung kann beispielsweise auch zu einer Steigerung der Absorptionswahrscheinlichkeit von Primärstrahlung in der Wellenlängenkonversionsschicht führen, wodurch eine geringere Schichtdicke der Wellenlängenkonversionsschicht erforderlich sein kann.

Die Verkapselungsanordnung kann derart auf der zweiten Elektrode aufgebracht werden, dass die erste Barrierenschicht auf der zweiten Elektrode und die erste Wellenlängenkonversionsschicht auf der ersten Barrierenschicht angeordnet ist. Weiterhin kann dabei vor dem Aufbringen der ersten Barrierenschicht auf der zweiten Elektrode eine Planarisierungsschicht, beispielsweise aus einem wie oben im Zusammenhang mit dem Matrixmaterial genannten Material, aufgebracht werden. Dadurch kann eine durchgehende Barrierenschicht auf der zweiten Elektrode ermöglicht werden. Die Planarisierungsschicht kann dabei eine Dicke aufweisen, die größer als die Unebenheiten der darunter liegenden Schicht, etwa der zweiten Elektrode, ist.

Weiterhin kann die erste Wellenlängenkonversionsschicht auf der zweiten Elektrode und die erste Barrierenschicht auf der ersten Wellenlängenkonversionsschicht aufgebracht werden. Dadurch kann die erste Wellenlängenkonversionsschicht zusätzlich die Funktion der oben genannten Planarisierungsschicht übernehmen.

Zusätzlich kann die Verkapselungsanordnung eine zweite Barrierenschicht aufweisen. Die zweite Barrierenschicht kann dabei wie oben im Zusammenhang mit der ersten Barrierenschicht aufgeführte Merkmale aufweisen. Die zweite Barrierenschicht kann dabei das gleiche oder ein anderes Material wie die erste Barrierenschicht aufweisen. Weiterhin kann die zweite Barrierenschicht das gleiche Material wie die erste Barrierenschicht aufweisen, dabei jedoch mit einer anderen Mikrostruktur und/oder Modifikation aufgebaut sein. So kann die erste Barrierenschicht beispielsweise als α-Aluminiumoxid vorliegen, während die zweite Barrierenschicht als γ-Aluminiumoxid vorliegen kann. Dadurch kann die Ausbildung von durchgehenden Mikrokanälen, so genannten "pin holes", die sich von einer der Barrierenschichten in die andere fortsetzen könnten, vermieden werden.

Die erste Wellenlängenkonversionsschicht kann weiterhin zwischen der ersten und zweiten Barrierenschicht angeordnet sein. Auch eine solche Anordnung kann die Ausbildung von durchgehenden "pin holes" in den Barrierenschichten vermeiden, wodurch die Permeabilität der Verkapselungsanordnung gegenüber Sauerstoff und/oder Feuchtigkeit vermindert werden kann.

Die Verkapselungsanordnung kann auch eine Mehrzahl von Barrierenschichten und eine Mehrzahl von Wellenlängenkonversionsschichten aufweisen. "Eine Mehrzahl von Schichten" kann dabei hier und im Folgenden zumindest zwei oder mehr Schichten bedeuten. Die Barrierenschichten der Mehrzahl von Barrierenschichten können dabei wie oben ausgeführt gleiche oder unterschiedliche Materialien und gleiche oder unterschiedliche Materialmodifikationen oder Mikrostrukturen aufweisen. Jede der Mehrzahl der Barrierenschichten beziehungsweise der Mehrzahl der Wellenlängenkonversionsschichten kann dabei oben genannte Merkmale bezüglich der ersten Barrierenschicht beziehungsweise der ersten Wellenlängenkonversionsschicht aufweisen.

Insbesondere können bei der Anordnung einer Mehrzahl von Barrierenschichten und/oder Wellenlängenkonversionsschichten die einzelnen Schichten beispielsweise jeweils eine geringere Dicke aufweisen als im Falle nur einer Barrierenschicht beziehungsweise Wellenlängenkonversionsschicht, ohne dass die Barriereeigenschaften beziehungsweise Wellenlängenkonversionseigenschaften der Verkapselungsanordnung gemindert würden. Durch die Verwendung von mehreren Barrierenschichten und/oder Wellenlängenkonversionsschichten, die jeweils eine geringe Dicke aufweisen, können die optischen Eigenschaften der Verkapselungsanordnung wie etwa die Auskoppeleffizienz und eine vom Betrachtungswinkel unabhängige Abstrahlung der Primärstrahlung und/oder Sekundärstrahlung verbessert werden. Je geringer die jeweilige Dicke der einzelnen Barrierenschichten und/oder Wellenlängenkonversionsschichten ist, desto geringer können beispielsweise die Wellenleitereigenschaften der jeweiligen einzelnen Schichten sein. Dazu kann beispielsweise zumindest die erste Barrierenschicht oder auch mehrere oder alle einer Mehrzahl von Barrierenschichten eine Dicke aufweisen, die kleiner oder gleich einer charakteristischen Wellenlänge der Primärstrahlung und/oder der Sekundärstrahlung sein kann. Weiterhin kann die Dicke kleiner oder gleich der halben oder einem Viertel der charakteristischen Wellenlänge der Primärstrahlung und/oder der Sekundärstrahlung sein. Die Dicke kann weiterhin größer oder gleich einem Zehntel oder auch größer oder gleich einem Achtel der charakteristischen Wellenlänge der Primärstrahlung und/oder der Sekundärstrahlung sein.

Die charakteristische Wellenlänge kann dabei die intensitätsstärkste Wellenlänge des Spektrums der Primärstrahlung beziehungsweise der Sekundärstrahlung bezeichnen. Alternativ kann die charakteristische Wellenlänge auch die mittlere Wellenlänge des Spektralbereichs, in dem die Primärstrahlung beziehungsweise die Sekundärstrahlung liegt, bezeichnen. Weiterhin kann die charakteristische Wellenlänge auch die über die einzelnen spektralen Intensitäten gewichtete mittlere Wellenlänge des Spektrums der Primärstrahlung beziehungsweise der Sekundärstrahlung bezeichnen. Die Primärstrahlung kann in diesem Sinne eine erste charakteristische Wellenlänge aufweisen und die Sekundärstrahlung eine zweite charakteristische Wellenlänge.

Weiterhin kann die Verkapselungsanordnung auf einer der strahlungsemittierenden Schichtenfolge abgewandten Oberfläche, die beispielsweise eine Strahlungsauskoppelfläche des optoelektronischen Bauelements sein kann, eine Oberflächenstruktur aufweisen. Eine solche Oberflächenstruktur kann Aufrauungen, Gräben, Prismen, Linsen oder Kegelstümpfe oder Kombinationen daraus aufweisen, die beispielsweise die Strahlungsauskopplung der Primärstrahlung und der Sekundärstrahlung aus der Verkapselungsanordnung erhöhen und verbessern können. Die Oberflächenstruktur kann dabei je nach Ausgestaltung der Verkapselungsanordnung in einer Barrierenschicht oder eine Wellenlängenkonversionsschicht ausgebildet sein. Alternativ oder zusätzlich kann die Verkapselungsanordnung auf der ersten Barrierenschicht und auf der ersten Wellenlängenkonversionsschicht, oder auf der Mehrzahl von Barrierenschichten und der Mehrzahl von Wellenlängenkonversionsschichten, eine äußere Schicht aufweisen, in der die Oberflächenstruktur ausgebildet ist. Die äußere Schicht kann beispielsweise ein wie weiter oben im Zusammenhang mit dem Matrixmaterial ausgeführtes Material, etwa ein Polymermaterial, aufweisen.

Die Verkapselungsanordnung kann die gesamte strahlungsemittierende Schichtenfolge mit den Elektroden bedecken. Weiterhin kann die Verkapselungsanordnung zumindest einen Teil der Oberfläche des Substrats bedecken, auf dem die strahlungsemittierende Schichtenfolge mit der ersten und zweiten Elektrode angeordnet sind. Zusätzlich kann die Verkapselungsanordnung auch das gesamte Substrat umgeben. Alternativ kann das Substrat zusammen mit der Verkapselungsanordnung eine Verkapselung für die Elektroden und die strahlungsemittierende Schichtenfolge bilden. Die Verkapselungsanordnung kann dabei weitere Schichten wie etwa Planarisierungsschichten, Barriereschichten, Wasser und/oder Sauerstoff absorbierende Schichten, Verbindungsschichten oder Kombinationen daraus aufweisen. Alternativ oder zusätzlich kann die Verkapselungsanordnung einen weiteren Schichtenstapel mit zumindest einer Barrierenschicht und/oder zumindest einer Wellenlängenkonversionsschicht auf einer der strahlungsemittierenden Schichtenfolge abgewandten Oberfläche des Substrats aufweisen.

Dadurch, dass die zweite Elektrode transparent für die Primärstrahlung ist und die Verkapselungsanordnung zumindest teilweise transparent für die Primärstrahlung und/oder die Sekundärstrahlung, kann das optoelektronische Bauelement als so genannter "top emitter" ausgeführt sein und die Primärstrahlung und/oder die Sekundärstrahlung von der Verkapselungsanordnung abstrahlen. Dadurch kann beispielsweise ein Substratmaterial unabhängig von seinen optischen Eigenschaften gewählt werden.

Das Substrat kann dabei Glas, Quarz, Kunststoff, Polymerfolien, Metall, Metallfolien, Siliziumwafer oder ein beliebiges anderes geeignetes Substratmaterial umfassen und starr oder flexibel ausgeführt sein. Zusätzlich kann das optoelektronische Bauelement als so genannter "bottom emitter" ausgeführt, das heißt, dass die im aktiven Bereich erzeugte Strahlung auch durch das Substrat abgestrahlt wird, so kann das Substrat transparent für zumindest einen Teil der im aktiven Bereich erzeugten elektromagnetischen Primärstrahlung sein. Das optoelektronische Bauelement kann auch als Kombination von "bottom emitter" und "top emitter" ausgeführt sein. Dabei kann das optoelektronische Bauelement in einem ausgeschalteten Zustand für sichtbares Licht oder zumindest einen Teil davon zumindest teilweise transparent sein.

Das optoelektronische Bauelement kann als strahlungsemittierende Schichtenfolge eine Halbleiterschichtenfolge aufweisen.

Besonders bevorzugt kann das optoelektronische Bauelement als organische lichtemittierende Diode (OLED) ausgeführt sein. Die OLED kann beispielsweise die erste Elektrode auf dem Substrat aufweisen. Über der ersten Elektrode kann ein funktionaler Bereich mit einer oder mehreren funktionalen Schichten aus organischen Materialien aufgebracht sein. Die funktionalen Schichten können dabei beispielsweise als Elektronentransportschichten, elektrolumineszierende Schichten und/oder Lochtransportschichten ausgebildet sein. Über den funktionalen Schichten kann eine zweite Elektrode aufgebracht sein. In den funktionellen Schichten kann im aktiven Bereich durch Elektronen- und Löcherinjektion und - rekombination elektromagnetische Strahlung mit einer einzelnen Wellenlänge oder einem Bereich von Wellenlängen erzeugt werden. Dabei kann bei einem Betrachter wie oben beschrieben durch Emission schmal- oder breitbandiger Primärstrahlung ein einfarbiger, ein mehrfarbiger und/oder ein mischfarbiger Leuchteindruck der Primärstrahlung erweckt werden.

Die funktionalen Schichten können organische Polymere, organische Oligomere, organische Monomere, organische kleine, nicht-polymere Moleküle ("small molecules") oder Kombinationen daraus aufweisen. Geeignete Materialien sowie Anordnungen und Strukturierungen der Materialien für funktionale Schichten sind dem Fachmann bekannt und werden daher an dieser Stelle nicht weiter ausgeführt.

Insbesondere können die erste Elektrode und/oder die zweite Elektrode besonders bevorzugt flächig oder alternativ in erste beziehungsweise zweite Elektrodenteilbereiche strukturiert ausgeführt sein. Beispielsweise kann die erste Elektrode in Form parallel nebeneinander angeordneter erster Elektrodenstreifen ausgeführt sein und die zweite Elektrode als senkrecht dazu verlaufende parallel nebeneinander angeordnete zweite Elektrodenstreifen. Überlappungen der ersten und zweiten Elektrodenstreifen können damit als separat ansteuerbare Leuchtbereiche ausgeführt sein. Weiterhin können auch nur die erste oder nur die zweite Elektrode strukturiert sein. Besonders bevorzugt sind die erste und/oder die zweite Elektrode oder Elektrodenteilbereiche elektrisch leitend mit ersten Leiterbahnen verbunden. Dabei kann eine Elektrode oder ein Elektrodenteilbereich beispielsweise in eine erste Leiterbahn übergehen oder getrennt von einer ersten Leiterbahn ausgeführt und elektrisch leitend mit dieser verbunden sein.

Die erste Elektrode, die beispielsweise als Anode ausgeführt sein kann und somit als Löcher-injizierendes Material dienen kann, kann beispielsweise ein transparentes elektrisch leitendes Oxid aufweisen oder aus einem transparenten leitenden Oxid bestehen. Transparente elektrisch leitende Oxide (transparent conductive oxides, kurz "TCO") sind transparente, leitende Materialien, in der Regel Metalloxide, wie beispielsweise Zinkoxid, Zinnoxid, Cadmiumoxid, Titanoxid, Indiumoxid oder besonders bevorzugt Indiumzinnoxid (ITO). Neben binären Metallsauerstoffverbindungen, wie beispielsweise ZnO, Sn0₂ oder In₂O₃ gehören auch ternäre Metallsauerstoffverbindungen, wie beispielsweise Zn₂Sn0₄, CdSn0₃, ZnSn0₃, MgIn₂0₄, GaInO₃, Zn₂In₂0₅ oder In₄Sn₃0₁₂ oder Mischungen unterschiedlicher transparenter elektrisch leitender Oxide zu der Gruppe der TCOs. Weiterhin müssen die TC0s nicht zwingend einer stöchiometrischen Zusammensetzung entsprechen und können auch p- oder n-dotiert sein. Die erste Elektrode kann dabei vorzugsweise auf dem Substrat angeordnet sein und beispielsweise auch Metalle und/oder Metalllegierungen und/oder Schichtfolgen aufweisen oder aus solchen sein, die zumindest eines der Materialien Ag, Al, Cr, Mo und Au umfassen.

Die zweite Elektrode kann als Kathode ausgeführt sein und somit als Elektronen-injizierendes Material dienen. Als Kathodenmaterial können sich unter anderem insbesondere Aluminium, Barium, Indium, Silber, Gold, Magnesium, Calcium oder Lithium sowie Verbindungen, Kombinationen und Legierungen davon als vorteilhaft erweisen. Die zweite Elektrode kann dabei eine Dicke von größer oder gleich 1 nm und kleiner oder gleich 50 nm, insbesondere größer oder gleich 10 nm und kleiner oder gleich 30 nm, aufweisen und somit transparent für die Primärstrahlung sein.

Weiterhin kann die zweite Elektrode auch eines der oben genannten TCOs umfassen oder aus einem solchen sein. Die zweite Elektrode kann beispielsweise mittels eines der weiter oben in Verbindung mit der ersten Barrierenschicht genannten CVD- und/oder PVD-Verfahren aufbringbar sein.

Alternativ können die erste Elektrode als Kathode und die zweite Elektrode als Anode mit den oben aufgeführten Materialien oder Kombinationen daraus ausgebildet sein. Weiterhin können die Elektroden auch elektrisch leitendes oder halbleitendes organisches Material aufweisen.

Weiterhin kann die strahlungsemittierende Schichtenfolge auch als Epitaxieschichtenfolge, also als epitaktisch gewachsene anorganische Halbleiterschichtenfolge, ausgeführt sein. Dabei kann die Halbleiterschichtenfolge beispielsweise auf der Basis eines anorganischen Materials, etwa InGaAlN, wie etwa als GaN-Dünnfilm-Halbleiterschichtenfolge, ausgeführt sein. Unter InGaAlN-basierte Halbleiterschichtenfolgen fallen insbesondere solche, bei denen die epitaktisch hergestellte Halbleiterschichtenfolge, die in der Regel eine Schichtenfolge aus unterschiedlichen Einzelschichten aufweist, mindestens eine Einzelschicht enthält, die ein Material aus dem III-V-Verbindungshalbleitermaterialsystem InₓAl_{y}Ga_{1-x-y}N mit 0 ≤ x ≤, 0 ≤ y ≤ 1 und x+y ≤ aufweist.

Alternativ oder zusätzlich kann die Halbleiterschichtenfolge auch auf InGaAlP basieren, das heißt, dass die Halbleiterschichtenfolge unterschiedliche Einzelschichten aufweist, wovon mindestens eine Einzelschicht ein Material aus dem III-V-Verbindungshalbleitermaterialsystem InₓAl_{y}Ga₁₋ₓ₋yP mit 0 ≤ x ≤ 1, 0 ≤ y ≤ 1 und x+y ≤ 1 aufweist. Alternativ oder zusätzlich kann die Halbleiterschichtenfolge auch andere III-V-Verbindungshalbleitermaterialsysteme, beispielsweise ein AlGaAs-basiertes Material, oder II-VI-Verbindungshalbleitermaterialsysteme aufweisen.

Ein Verfahren zur Herstellung eines optoelektronischen Bauelements gemäß zumindest einer weiteren Ausführungsform umfasst insbesondere die Schritte
A) Bereitstellen eines Substrats mit einer ersten Elektrode, einer strahlungsemittierenden Schichtenfolge auf der ersten Elektrode und einer zweiten Elektrode auf der strahlungsemittierenden Schichtenfolge,
B) Aufbringen einer Verkapselungsanordnung mit einem Schichtenstapel aus zumindest einer ersten Barrierenschicht und zumindest einer ersten Wellenlängenkonversionsschicht.

Das optoelektronische Bauelement kann dabei eines oder mehrere der oben genannten Merkmale aufweisen.

Weiterhin kann dabei im Schritt B die zumindest eine erste Barrierenschicht mittels eines Aufdampf- oder eines Aufwachsverfahrens wie weiter oben beschrieben aufgebracht werden. Das kann bedeuten, dass beispielsweise zumindest eine erste Barrierenschicht mittels eines Aufdampf- oder eines Aufwachsverfahrens aufbringbar ist.

Insbesondere kann das Verfahren im Schritt B die Teilschritte
B1) Aufbringen der ersten Barrierenschicht auf der zweiten Elektrode und
B2) Aufbringen der ersten Wellenlängenkonversionsschicht auf der ersten Barrierenschicht
   umfassen

Alternativ kann das Verfahren im Schritt B die Teilschritte
B1') Aufbringen der Wellenlängenkonversionsschicht auf der zweiten Elektrode und
B2') Aufbringen der ersten Barrierenschicht auf der Wellenlängenkonversionsschicht
   umfassen.

In einem weiteren Teilschritt B3 kann auf der ersten Barrierenschicht und der ersten Wellenlängenkonversionsschicht eine zweite Barrierenschicht aufgebracht werden.

Weiterhin können im Schritt B eine Mehrzahl von Barrierenschichten und eine Mehrzahl von Wellenlängenkonversionsschichten abwechselnd aufgebracht werden.

In einem weiteren Verfahrensschritt C kann wie oben beschrieben eine Oberflächenstruktur auf der der strahlungsemittierenden Schichtenfolge abgewandten Oberfläche der Verkapselungsanordnung aufgebracht werden. Dabei kann in Schritt C die Oberflächestruktur durch Prägen, Ätzen, Aufrauen oder Laserabtragung oder eine Kombination daraus aufgebracht werden.

Weitere Vorteile und vorteilhafte Ausführungsformen und Weiterbildungen der Erfindung ergeben sich aus den im Folgenden in Verbindung mit den Figuren 1A bis 6E beschriebenen Ausführungsformen.

Es zeigen:
Figuren 1A bis 1C schematische Darstellungen eines Verfahrens zur Herstellung eines optoelektronischen Bauelements gemäß einem Ausführungsbeispiel und
Figuren 2 bis 7 schematische Darstellung optoelektronischer Bauelemente gemäß weiteren Ausführungsbeispielen.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben dick oder groß dimensioniert dargestellt sein.

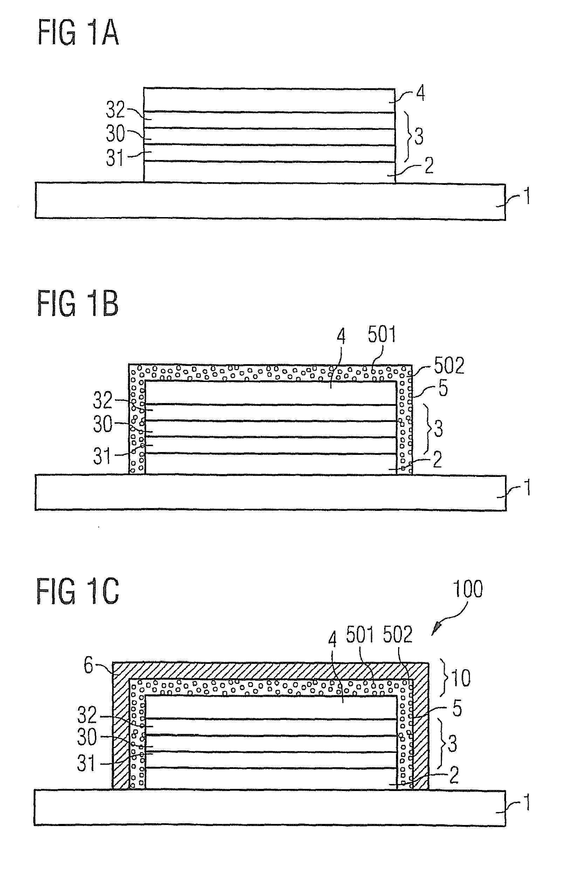

In den Figuren 1A bis 1C ist ein Verfahren zur Herstellung eines organischen optoelektronischen Bauelements 100 gezeigt.

Dabei wird in einem ersten Verfahrensschritt A gemäß Figur 1A ein Substrat 1 bereitgestellt, etwa ein Glassubstrat. Alternativ oder zusätzlich kann das Substrat 1 auch beispielsweise eine Metallfolie oder Plastikfolie aufweisen oder sein. Auf das Substrat 1 ist eine erste Elektrode 2 aufgebracht. Auf der ersten Elektrode 2 ist eine strahlungsemittierende Schichtenfolge 3 mit funktionalen Schichten 31 und 32 und einem aktiven Bereich 30 angeordnet. Im gezeigten Ausführungsbeispiel ist das optoelektronische Bauelement als organische Leuchtdiode (OLED) ausgeführt. Die strahlungsemittierende Schichtenfolge 3 weist damit organische funktionale Schichten wie im allgemeinen Teil beschrieben auf. Auf der strahlungsemittierenden Schichtenfolge 3 ist eine zweite Elektrode 4 angeordnet.

Der aktive Bereich 30 ist geeignet, beim Anlegen eines elektrischen Stromes an die erste und zweite Elektrode 2, 4 eine elektromagnetische Primärstrahlung in einem blauen Wellenlängenbereich abzustrahlen. Die zweite Elektrode 4 weist ein Metall oder ein TCO auf und ist transparent für die Primärstrahlung.

In einem weiteren Verfahrensschritt B wird, wie in den Figuren 1B und 1C gezeigt, eine Verkapselungsanordnung 10 auf der zweiten Elektrode aufgebracht. Dabei wird, wie in Figur 1B gezeigt, in einem ersten Teilschritt B1 eine Wellenlängenkonversionsschicht 5 mit einem Wellenlängenkonversionsstoff 501 eingebettet in einem Matrixmaterial 502 aus flüssiger Phase aufgebracht. Das Matrixmaterial weist dabei einen transparenten Kunststoff, im gezeigten Ausführungsbeispiel Silikon, auf. Durch Vernetzung des Matrixmaterials 502 wird die Wellenlängenkonversionsschicht 5 ausgehärtet.

Der Wellenlängenkonversionsstoff 501 ist geeignet, die blaue Primärstrahlung teilweise zu absorbieren und gelbe Sekundärstrahlung zu emittieren. Durch Überlagerung der Primärstrahlung und der Sekundärstrahlung kann das optoelektronische Bauelement 100 im Betrieb einen weißfarbigen Leuchteindruck bei einem Beobachter erwecken.

In einem weiteren Teilschritt B2 wird, wie in Figur 1C gezeigt, auf der Wellenlängenkonversionsschicht 5 eine Barrierenschicht 6 aufgebracht. Die Barrierenschicht 6 wird mittels eines CVD-Verfahrens aufgebracht und schützt die Elektroden 2, 4 und die strahlungsemittierende Schichtenfolge 3 vor Schädigungen durch Sauerstoff und/oder Feuchtigkeit. Die Barrierenschicht 6 weist dazu Aluminiumoxid auf. Alternativ oder zusätzlich kann auch ein anderes Material aus den im allgemeinen Teil genannten Materialien aufgebracht werden. Durch das Matrixmaterial 502 der Wellenlängenkonversionsschicht 5 dient die Wellenlängenkonversionsschicht 5 gleichzeitig als Planarisierungsschicht auf der zweiten Elektrode 4, auf der die Barrierenschicht 6 homogen und gleichmäßig aufgebracht werden kann.

Die Verkapselungsanordnung 10, umfassend den Schichtenstapel mit der Wellenlängenkonversionsschicht 5 und der Barrierenschicht 6, verkapselt zusammen mit dem Substrat 1 die strahlungsemittierende Schichtenfolge 3 und die Elektroden 2, 4.

Beim optoelektronischen Bauelement 100 können die Vorteile des Konversionskonzepts genutzt werden, nämlich die Vermeidung einer differenziellen Farbalterung des aktiven Bereichs 30 sowie die getrennte Optimierung des wahrnehmbaren Farborts und der elektronischen Eigenschaften der strahlungsemittierenden Schichtenfolge 3. Weiterhin können die vorteile des "top emitter"-Konzepts genutzt werden, nämlich die Möglichkeit, unabhängig von seinen optischen Eigenschaften das Substrat 1 wählen zu können, sowie eine gute Strahlungsauskopplung aus der Verkapselungsanordnung 10 sowie eine preiswerte und technisch einfach herzustellende Verkapselung.

In den folgenden Figuren sind weitere Ausführungsbeispiele gezeigt, die Variationen des in den Figuren 1A bis 1C gezeigten Ausführungsbeispiels darstellen. die nachfolgende Beschreibung bezieht sich daher im Wesentlichen auf die Unterschiede zum vorangegangenen Ausführungsbeispiel.

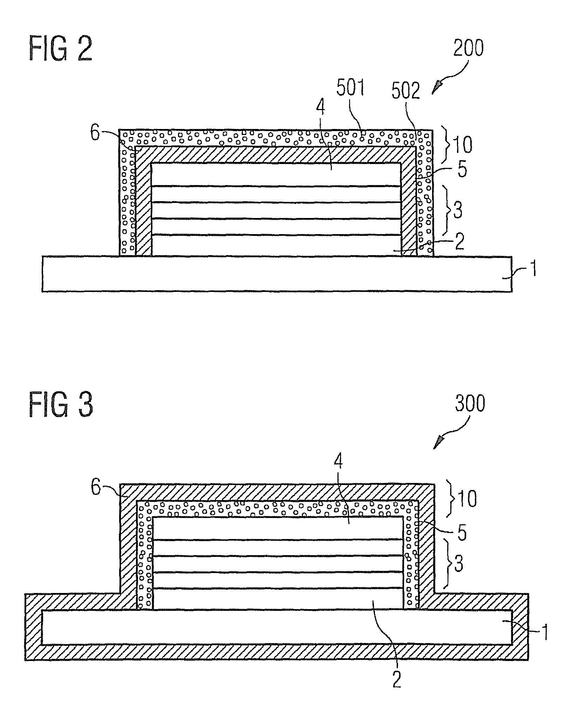

In Figur 2 ist ein Ausführungsbeispiel für ein optoelektronisches Bauelement 200 gezeigt. Das optoelektronische Bauelement 200 weist eine Verkapselungsanordnung 10 auf, die eine Barrierenschicht 6 auf der zweiten Elektrode 4 aufweist. Auf der Barrierenschicht 6, die mittels eines ersten Verfahrensteilschritts B1' auf der zweiten Elektrode 4 aufgebracht ist, ist mittels eines zweiten Verfahrensteilschritts B2' eine Wellenlängenkonversionsschicht 5 aufgebracht. Die Verkapselungsanordnung 10 kann weiterhin zwischen der zweiten Elektrode 4 und der Barrierenschicht 6 eine Panarisierungsschicht (nicht gezeigt) aufweisen.

In Figur 3 ist ein Ausführungsbeispiel für ein optoelektronisches Bauelement 300 gezeigt, bei den die Verkapselungsanordnung 10 wie beim optoelektronischen Bauelemente 100 der Figuren 1A bis 1C eine Barrierenschicht 6 auf der Wellenlängenkonversionsschicht 5 aufweist. Die Barrierenschicht 6 umhüllt zusätzlich das Substrat 1, so dass durch die Barrierenschicht 6 und damit durch die Verkapselungsanordnung 10 das Substrat 1 zusammen mit den Elektroden 2, 4 und der strahlungsemittierenden Schichtenfolge 3 verkapselt ist. Die Verkapselungsanordnung 10 kann dazu auf dem Substrat weitere Schichten wie etwa Planarisierungsschichten oder weitere Barrierenschicht aufweisen (nicht gezeigt.)

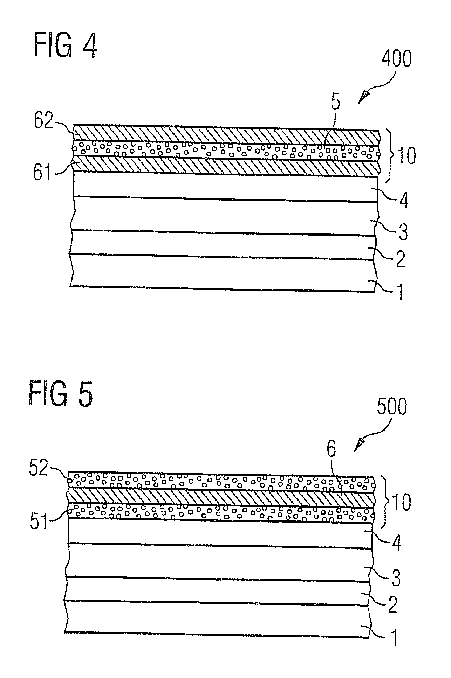

Die Figuren 4 bis 7 zeigen Ausschnitte aus optoelektronischen Bauelementen gemäß weiterer Ausführungsbeispiele. In Figur 4 ist ein optoelektronisches Bauelement 400 mit einer Verkapselungsanordnung 10 mit einem Schichtenstapel gezeigt, der eine erste Barrierenschicht 61 auf der zweiten Elektrode 4 aufweist. Darüber ist eine Wellenlängenkonversionsschicht 5 aufgebracht, auf der eine zweite Barrierenschicht 62 angeordnet ist. Die erste Barrierenschicht 61 und die zweite Barrierenschicht 62 sind somit durch die Wellenlängenkonversionsschicht 5 voneinander getrennt. Dadurch kann erreicht werden, dass sich Mikrokanäle, die beispielsweise in der ersten Barrierenschicht 61 auftreten können und die Permeationspfade für Sauerstoff und/oder Feuchtigkeit darstellen können, beim anschließenden Aufwachsen der zweiten Barrierenschicht 62 nicht fortsetzen können, da die erste und zweite Barrierenschicht 61, 62 durch die Wellenlängenkonversionsschicht 5 voneinander getrennt sind. Dadurch kann eine Verbesserung der Verkapselungswirkung durch eine Verringerung der Permeabilität der Verkapselungsanordnung 10 erreicht werden, wodurch beispielsweise eine geringere Gesamtdicke der Barrierenschicht 61 und 62 im Vergleich zu den Barrierenschichten 6 der vorangegangenen Ausführungsbeispiele möglich sein kann.

In Figur 5 ist ein Ausführungsbeispiel für ein optoelektronisches Bauelement 500 gezeigt, dass eine Verkapselungsanordnung 10 mit einer ersten Wellenlängenkonversionsschicht 51 auf der zweiten Elektrode 4 aufweist. Darüber ist eine erste Barrierenschicht 6 aufgebracht und auf dieser ist eine zweite Wellenlängenkonversionsschicht 52 angeordnet. Die beiden Wellenlängenkonversionsschichten 51, 52 können gleich oder verschieden voneinander sein. Durch die Verkapselungsanordnung 10 im gezeigten Ausführungsbeispiel kann beispielsweise eine Winkelabhängigkeit der vom optoelektronischen Bauelement 500 abgestrahlten überlagerten Primärstrahlung und Sekundärstrahlung verringert werden und die Auskoppeleffizienz gesteigert werden.

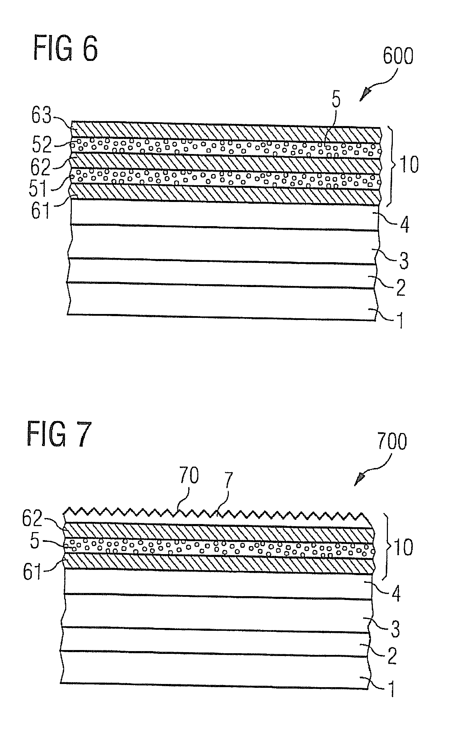

In Figur 6 ist ein Ausführungsbeispiel für ein optoelektronisches Bauelement 600 gezeigt, das die Vorteile der beiden vorangehenden Ausführungsbeispiele kombiniert. die Verkapselungsanordnung 10 des optoelektronischen Bauelement 600 weist eine Schichtenstapel mit einer Mehrzahl an Barrierenschichten 61, 62, 63 und einer Mehrzahl von Wellenlängenkonversionsschichten 51, 52 auf, die abwechselnd übereinander angeordnet sind. Die jeweiligen Anzahlen der Barrierenschichten und Wellenlängenkonversionsschichten sind rein beispielhaft und können vom gezeigten Ausführungsbeispiel auch abweichen. Durch die abwechselnde Anordnung der Mehrzahl von Barrierenschichten 61, 62, 63 und Wellenlängenkonversionsschichten 51, 52 kann die Bildung von durchgehenden Mikrokanälen durch die Verkapselungsanordnung 10 wirkungsvoll vermieden werden. Durch Mehrzahl von Barrierenschichten kann die Dicke der einzelnen Barrierenschichten 61, 62, 63 beispielsweise als etwa ein Viertel der charakteristischen Wellenlänge der Primärstrahlung oder der Sekundärstrahlung gewählt werden, wodurch Wellenleitereffekte in den Barrierenschichten und damit in der Verkapselungsanordnung 10 vermieden werden können. Gleichzeitig kann durch die Mehrzahl der Wellenlängenkonversionsschichten 51, 52 der Farbort des durch das optoelektronische Bauelement erweckten Leuchteindrucks leicht optimiert werden. Dadurch bietet die Verkapselungsanordnung 10 eine effektive Verkapselungswirkung bei gleichzeitiger gesteigerter Auskoppeleffizienz der abgestrahlten elektromagnetischen Strahlung.

Das optoelektronische Bauelement 700 des Ausführungsbeispiels in Figur 7 zeigt auf der der strahlungsemittierenden Schichtenfolge 3 abgewandten Oberfläche der Verkapselungsanordnung 10 eine Oberflächenstruktur 70 auf, durch die die Auskoppeleffizienz für die abgestrahlte elektromagnetische Strahlung noch weiter gesteigert werden kann. Im gezeigten Ausführungsbeispiel ist die Oberflächenstruktur 70 in einer äußeren Schicht 7, die durch eine zusätzliche Polymerschicht gebildet ist, hergestellt. Alternativ dazu kann eine solche Oberflächenstruktur 70, die im gezeigten Ausführungsbeispiel als Mikroprismen ausgeführt ist, auch in einer Barrierenschicht oder eine Wellenlängenkonversionsschicht der vorangegangenen Ausführungsbeispiele hergestellt werden.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Optoelektronisches Bauelement, umfassend
- ein Substrat (1),
- eine erste Elektrode (2) auf dem Substrat (1),
- eine strahlungsemittierende Schichtenfolge (3) mit einem aktiven Bereich (30), der im Betrieb eine elektromagnetische Primärstrahlung abstrahlt,
- eine für die Primärstrahlung transparente zweite Elektrode (4) auf der strahlungsemittierenden Schichtenfolge (3) und
- eine auf der zweiten Elektrode (4) abgeschiedene Verkapselungsanordnung (10),
wobei
- die Verkapselungsanordnung (10) einen Schichtenstapel mit zumindest einer ersten Barrierenschicht (6) und zumindest einer ersten, die Primärstrahlung zumindest teilweise in elektromagnetische Sekundärstrahlung umwandelnden Wellenlängenkonversionsschicht (5) aufweist und
- die Verkapselungsanordnung (10) zumindest teilweise für die Primärstrahlung und/oder für die Sekundärstrahlung transparent ist,
**dadurch gekennzeichnet, dass**
- die Verkapselungsanordnung (10) eine Mehrzahl von Barrierenschichten (61, 62, 63) und eine Mehrzahl von Wellenlängenkonversionsschichten (51, 52) aufweist, die abwechselnd übereinander angeordnet sind.

2. Optoelektronische Vorrichtung nach dem vorherigen Anspruch, wobei
- die erste Barrierenschicht (6) ein Oxid, ein Nitrid oder ein Oxynitrid umfasst und
- das Oxid, Nitrid oder Oxynitrid Aluminium, Silizium, Zinn oder Zink aufweist.

3. Optoelektronisches Bauelement nach einem der vorherigen Ansprüche, wobei
- die erste Barrierenschicht (6) auf der zweiten Elektrode (4) und die erste Wellenlängenkonversionsschicht (5) auf der ersten Barrierenschicht (6) angeordnet ist.

4. Optoelektronisches Bauelement nach Anspruch 1 oder 2, wobei
- die erste Wellenlängenkonversionsschicht (5) auf der zweiten Elektrode (4) und die erste Barrierenschicht (6) auf der ersten Wellenlängenkonversionsschicht (5) angeordnet ist.

5. Optoelektronisches Bauelement nach einem der vorherigen Ansprüche, wobei
- die Verkapselungsanordnung (10) eine zweite Barrierenschicht (62) aufweist und
- die erste Wellenlängenkonversionsschicht (5) zwischen der ersten und zweiten Barrierenschicht (61, 62) angeordnet ist.

6. Optoelektronisches Bauelement nach einem der vorherigen Ansprüche, wobei
- die einzelnen Barrierenschichten der Mehrzahl von Barrierenschichten (61, 62, 63) jeweils eine Dicke aufweisen, die kleiner oder gleich einer charakteristischen Wellenlänge der Primärstrahlung oder der Sekundärstrahlung ist.

7. Optoelektronisches Bauelement nach einem der vorherigen Ansprüche, wobei
- die Verkapselungsanordnung (10) auf einer der strahlungsemittierenden Schichtenfolge (3) abgewandten Oberfläche eine Oberflächenstruktur (70) aufweist.

8. Optoelektronisches Bauelement nach dem vorherigen Anspruch, wobei
- die Oberflächenstruktur (70) zumindest eines von Aufrauungen, Gräben, Prismen, Linsen oder Kegelstümpfen umfasst.

9. Optoelektronisches Bauelement nach Anspruch 7 oder 8, wobei
- die Verkapselungsanordnung eine äußere Schicht (7) aufweist, auf der die Oberflächenstruktur (70) vorhanden ist.

10. Optoelektronisches Bauelement nach einem der vorherigen Ansprüche, wobei
- die Verkapselungsanordnung (10) einen weiteren Schichtenstapel mit zumindest einer Barrierenschicht und zumindest einer Wellenlängenkonversionsschicht auf einer der strahlungsemittierenden Schichtenfolge abgewandten Oberfläche des Substrats (1) aufweist.

11. Verfahren zur Herstellung eines optoelektronischen Bauelements mit den Schritten:
A) Bereitstellen eines Substrats (1) mit einer ersten Elektrode (2), einer strahlungsemittierenden Schichtenfolge (3) auf der ersten Elektrode (2) und einer zweiten Elektrode (4) auf der strahlungsemittierenden Schichtenfolge (3),
B) Aufbringen einer Verkapselungsanordnung (10) mit einem Schichtenstapel aus zumindest einer ersten Barrierenschicht (6) und zumindest einer ersten Wellenlängenkonversionsschicht (5) auf der strahlungsemittierenden Schichtenfolge,
**dadurch gekennzeichnet, dass**
- als Verkapselungsanordnung (10) eine Mehrzahl von Barrierenschichten (61, 62, 63) und eine Mehrzahl von Wellenlängenkonversionsschichten (51, 52) abwechselnd übereinander angeordnet werden.

12. Verfahren nach Anspruch 11, bei dem der Schritt B
folgende Teilschritte umfasst:
B1) Aufbringen der ersten Barrierenschicht (6) auf der zweiten Elektrode (4) und
B2) Aufbringen der ersten Wellenlängenkonversionsschicht (5) auf der ersten Barrierenschicht (6).

13. Verfahren nach Anspruch 11, bei dem der Schritt B folgende Teilschritte umfasst:
B1') Aufbringen der Wellenlängenkonversionsschicht (5) auf der zweiten Elektrode (4) und
B2') Aufbringen der ersten Barrierenschicht (6) auf der Wellenlängenkonversionsschicht (5).

14. Verfahren nach Anspruch 12, bei dem der Schritt B folgenden weiteren Teilschritt umfasst:
B3) Aufbringen einer zweiten Barrierenschicht (62) auf der ersten Barrierenschicht (61) und der ersten Wellenlängenkonversionsschicht (5).

15. Verfahren nach einem der Ansprüche 11 bis 14, mit dem weiteren Schritt
C) Aufbringen einer Oberflächenstruktur (70) auf ein der strahlungsemittierenden Schichtenfolge (3) abgewandten Oberfläche der Verkapselungsanordnung (10).
